# EUROPEAN PATENT APPLICATION

(11) **EP 4 543 174 A1**
(43) Date of publication of application: **23.04.2025**
(21) Application number: 22965533.7
(22) Date of filing: 17.11.2022
(51) Int. Cl.: H10K 59/12, G02B 3/04

(54) **DISPLAY PANEL AND DISPLAY DEVICE**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: YANG, Zongshun, Beijing 100176 (CN); YU, Hongtao, Beijing 100176 (CN); ZHANG, Yunhao, Beijing 100176 (CN); SU, Dongdong, Beijing 100176 (CN); YU, Zhongxiang, Beijing 100176 (CN); YANG, Chao, Beijing 100176 (CN); ZHANG, Fushuang, Beijing 100176 (CN); HUANG, Kuanta, Beijing 100176 (CN); BU, Weiliang, Beijing 100176 (CN)
(74) Representative: Potter Clarkson
(86) International application number: PCT/CN2022/132650
(87) International publication number: WO 2024/103351

(57) **Abstract**

The present disclosure relates to the technical field of display, and disclosed are a display panel and a display device. The display panel comprises a driving backplane (BP), light-emitting diodes (LD), a color film layer (CFL) and a lens layer (LL), wherein the light-emitting diodes (LD) are located on one side of the driving backplane (BP); a color filter (CF) of the color film layer (CFL) overlaps with one light-emitting diode (LD); the color filter (CF) comprises a first color filter (CF1), and the color filter (CF) further comprises a middle area (MA) and an edge area (EA); the surface of the first color filter (CF1) is recessed towards the driving backplane (BP); and the lens layer (LL) comprises a plurality of lenses (LENS), which are distributed in an array, wherein each lens (LENS) comprises a top surface (TS) and a side surface (SS), and the lens (LENS) further comprises a first lens (LENS1), which overlaps with the first color filter (CF1). In the first lens (LENS 1) and the first color filter (CF1) overlapping therewith, the middle area (MA) overlaps with the top surface (TS), and the side surface (SS) overlaps with the edge area (EA). The curvature of any point on the contour of the top surface (TS) is less than that of any point on the contour of the side surface (SS); the curvature difference between the contour of the middle area (MA) and the contour of the top surface (TS) is the central curvature difference between the lens (LENS) and the color filter (CF) overlapping therewith, and the curvature difference between the contour of the side surface (SS) and the contour of the edge area (EA) is the edge curvature difference between the lens (LENS) and the color filter (CF) overlapping therewith; and the central curvature difference is less than the edge curvature difference.

## Description

### TECHNICAL FIELD

The present disclosure relates to the field of display technologies, and specifically to a display panel and a display device.

### BACKGROUND

With the development of display technologies, display panels have been widely used in various electronic devices such as mobile phones for achieving image display and touch control operations. In the display panels, the organic light-emitting diode (OLED) display panel is a relatively common type. In the prior art, in order to increase brightness, it is usually required to reduce the view angle. Excessive reduction of the view angle will limit user's viewing range.

It should be noted that the information disclosed in the BACKGROUND section above is only used to enhance understanding of the background of the present disclosure, and thus may include information that does not constitute the prior art known to those ordinary skilled in the art.

### SUMMARY

The present disclosure provides a display panel and a display device.

According to an aspect of the present disclosure, there is provided a display panel, including:
a driving backplane;
a plurality of light-emitting units, arranged in an array at a side of the driving backplane;
a color film layer, located at a side of the light-emitting unit away from the driving backplane, and including a plurality of light-filtering parts, where one of the light-filtering parts is overlapped with one of the light-emitting units; the light-filtering parts comprise a first light-filtering part; the light-filtering part is away from and includes a middle region and an edge region surrounding the middle region; and a surface of the first light-filtering part away from the driving backplane is recessed towards the driving backplane; and
a lens layer, located on a surface of the color film layer away from the driving backplane, and including a plurality of lenses arranged in an array, where one of the lenses is overlapped with one of the light-filtering parts; the lens includes a top surface and a side surface surrounding an edge of the top surface; the side surface is a curved surface contracted towards the top surface; the lenses include a first lens overlapped with the first light-filtering part; and in one of first lenses and the first light-filtering part overlapped with the one of the first lenses, the middle region is overlapped with the top surface, and the side surface is overlapped with the edge region; where
in a cross section of one of the lenses and the light-filtering part overlapped with the one of the lenses, where the cross section is perpendicular to the driving backplane:
   a curvature of any point of a contour of the top surface is smaller than a curvature of any point of a contour of the side surface;
   a curvature difference between two points opposite to each other, in a direction perpendicular to the driving backplane, of a contour of the middle region and the contour of the top surface is a center curvature difference between the lens and the light-filtering part overlapped with the lens;
   a curvature difference between two points opposite to each other, in the direction perpendicular to the driving backplane, of the contour of the side surface and a contour of the edge region is an edge curvature difference between the lens and the light-filtering part overlapped with the lens; and
   the center curvature difference is smaller than the edge curvature difference.

In an exemplary embodiment of the present disclosure, an orthographic projection of the side surface on the driving backplane is in an annular shape; and an orthographic projection of the top surface on the driving backplane has a greater width than the orthographic projection of the side surface on the driving backplane.

In an exemplary embodiment of the present disclosure, the center curvature difference between the first lens and the first light-filtering part overlapped with the first lens is smaller than 10% of the edge curvature difference between the first lens and the first light-filtering part.

In an exemplary embodiment of the present disclosure, the lenses further include a second lens; the light-filtering parts further include a second light-filtering part provided with a color different from a color of the first light-filtering part; and the second light-filtering part is overlapped with the second lens; and
the center curvature difference between the first lens and the first light-filtering part overlapped with the first lens is greater than the center curvature difference between the second lens and the second light-filtering part overlapped with the second lens.

In an exemplary embodiment of the present disclosure, portions of edge regions of two adjacent ones of the light-filtering parts are stacked along a direction away from the driving backplane, and a width of a stacking zone is a stacking width of the two adjacent ones of the light-filtering parts.

In an exemplary embodiment of the present disclosure, a surface of the middle region of the second light-filtering part away from the driving backplane is parallel to the driving backplane, and a surface of the edge region of the second light-filtering part away from the driving backplane is curved along a direction close to the driving backplane; and
one first light-filtering part is adjacent to at least one second light-filtering part; and in the first light-filtering part and the second light-filtering part adjacent to each other, the edge region of the first light-filtering part is partially stacked on a side of the edge region of the second light-filtering part away from the driving backplane.

In an exemplary embodiment of the present disclosure, a width of an orthographic projection, on the driving backplane, of the side surface of the first lens is greater than the stacking width of the first light-filtering part and the second light-filtering part adjacent to the first light-filtering part.

In an exemplary embodiment of the present disclosure, the lenses further include a third lens; the light-filtering parts further include a third light-filtering part provided with a color different from the color of the first light-filtering part and the color of the second light-filtering part; and the third light-filtering part is overlapped with the third lens; and
one third light-filtering part is adjacent to at least one first light-filtering part and at least one second light-filtering part simultaneously; in the third light-filtering part and the first light-filtering part adjacent to each other, a portion of a surface of the edge region of the third light-filtering part away from the driving backplane is curved along the direction away from the driving backplane, and is stacked at a side of the edge region of the first light-filtering part away from the driving backplane; and in the third light-filtering part and the second light-filtering part adjacent to each other, a portion of a surface of the edge region of the third light-filtering part away from the driving backplane is curved along the direction close to the driving backplane, and is stacked on a side of the edge region of the second light-filtering part close to the driving backplane.

In an exemplary embodiment of the present disclosure, the lenses are arranged at intervals, a spacing between two adjacent ones of the lenses is a lens spacing, and a width of an orthographic projection of the side surface on the driving backplane is greater than the lens spacing.

In an exemplary embodiment of the present disclosure, the lenses are arranged at intervals, a spacing between two adjacent ones of the lenses is a lens spacing, and the lens spacing is smaller than the stacking width.

In an exemplary embodiment of the present disclosure, an area of an orthographic projection of the top surface on the driving backplane is not smaller than one-third of an area of an orthographic projection of the lens on the driving backplane.

In an exemplary embodiment of the present disclosure, an orthographic projection of the lens on the driving backplane is located within an orthographic projection, on the driving backplane, of the light-filtering part overlapped with the lens; and an area of the orthographic projection of the lens on the driving backplane is 0.7 to 0.8 times an area of the orthographic projection, on the driving backplane, of the light-filtering part overlapped with the lens.

In an exemplary embodiment of the present disclosure, a thickness of the lens layer is greater than a width of an orthographic projection of the top surface on the driving backplane.

In an exemplary embodiment of the present disclosure, the lens layer further includes a substrate, and the lenses are located on a surface of the substrate away from the driving backplane.

In an exemplary embodiment of the present disclosure, the lenses are arranged at intervals, a spacing between two adjacent ones of the lenses is a lens spacing, and the lens spacing is smaller than a thickness of the substrate.

In an exemplary embodiment of the present disclosure, the lens spacing ranges from 0.3 µm to 0.5 µm; a thickness of the light-filtering part ranges from 1.2 µm to 1.4 µm; and the stacking width ranges from 0.5 µm - 0.9 µm.

In an exemplary embodiment of the present disclosure, the top surface is planar, and is smoothly transitioned with the side surface.

In an exemplary embodiment of the present disclosure, the display panel further includes:
a color film planarization layer, covering the light-filtering parts; where
the lens layer is located on a surface of the color film planarization layer away from the driving backplane.

In an exemplary embodiment of the present disclosure, the display panel further includes:
an adhesive layer, covering the lens layer, where the adhesive layer has a smaller refractive index than the lens; and
a transparent cover plate, located on a surface of the adhesive layer away from the driving backplane.

According to an aspect of the present disclosure, there is provided a display device including the display panel as described in any of the foregoing.

It should be understood that the above general description and the subsequent detailed description are exemplary and explanatory only, and cannot limit the present disclosure.

### BRIEF DESCRIPTION OF THE DRAWINGS

The accompanying drawings herein, which are incorporated into and form a part of the specification, illustrate embodiments consistent with the present disclosure and are used in conjunction with the specification to explain the principles of the present disclosure. It will be apparent that the accompanying drawings in the following description are only some of the embodiments of the present disclosure, and that other accompanying drawings can be obtained based on these drawings without creative labor for those ordinary skilled in the art.
FIG. 1 is a partial cross-sectional view of a display panel in an embodiment of the present disclosure.
FIG. 2 is a partial cross-sectional view of a driving backplane, a first electrode and a pixel definition layer in an embodiment of a display panel of the present disclosure.
FIG. 3 is a partial cross-sectional view of a driving backplane and a light-emitting unit in an embodiment of a display panel of the present disclosure.
FIG. 4 is a partial cross-sectional view of a driving backplane, a light-emitting unit and a color film layer in an embodiment of a display panel of the present disclosure.
FIG. 5 is a partial cross-sectional view of a driving backplane, a light-emitting unit, a color film layer, and a lens layer in an embodiment of a display panel of the present disclosure.
FIG. 6 is a principle diagram of a lens in an embodiment of a display panel of the present disclosure.
FIG. 7 is a partial cross-sectional view of a display panel in another embodiment of the present disclosure.
FIG. 8 is a partial cross-sectional view of a driving backplane, a light-emitting unit, a color film layer, and a lens layer in another embodiment of a display panel of the present disclosure.
FIG. 9 is a principle diagram of a lens in another embodiment of a display panel of the present disclosure.
FIG. 10 is a schematic diagram of a light-emitting unit in an embodiment of a display panel of the present disclosure.
FIG. 11 is a partial top view of a pixel opening in an embodiment of a display panel of the present disclosure.

### DETAILED DESCRIPTION

Exemplary embodiments are now described more comprehensively with reference to the accompanying drawings. However, the exemplary embodiments are capable of being implemented in a variety of forms and should not be construed as being limited to the examples set forth herein. Rather, the provision of these embodiments allows for the present disclosure to be comprehensive and complete, and conveys the idea of the exemplary embodiments in a comprehensive manner to those skilled in the art. The same reference numerals in the drawings indicate the same or similar structures, and therefore their detailed descriptions will be omitted. In addition, the accompanying drawings are only schematic illustrations of the present disclosure and are not necessarily drawn to scale.

The terms "a", "an", "the", "said", and "at least one" are used for indicating an existence of one or more elements/components/etc.; and the terms "include" and "have" are used for indicating an open-ended inclusion and mean that there may be additional elements/components/etc. in addition to the listed elements/components/etc. The terms "first", "second" and "third", etc. are used merely as markers and not as quantitative limitations to the objects thereof.

The A being "overlapped" with B in this article refers to the existence of an overlapping zone between the orthographic projections of A and B on the driving backplane or other planes parallel to the driving backplane. It can be understood that A and B may be in direct contact with each other, or may be arranged at intervals in a direction perpendicular to the driving backplane.

In the related art, a silicon-based OLED display panel includes a driving backplane, a light-emitting functional layer and a color film layer, where: the light-emitting functional layer is located at a side of the driving backplane and includes a plurality of light-emitting units, and the light-emitting unit may include a first electrode (anode), a light-emitting layer and a second electrode (cathode) that are sequentially stacked along a direction away from the driving backplane. Through applying an electrical signal to the first electrode and the second electrode, the light-emitting layer may be driven to emit light, and the specific luminous principle of the light-emitting unit will not be described in detail herein.

In addition, the light-emitting layers of the light-emitting units may be formed through direct evaporation plating with a fine mask (FMM), and the light-emitting layers of the light-emitting units are arranged at intervals and emit light independently, thereby achieving color display. However, it is difficult to achieve a high PPI (pixels per inch) due to limitations of the manufacturing process of the fine mask. Therefore, color display may also be achieved by matching the monochromatic light or white light with the color film, that is, the light-emitting units share a same continuous light-emitting layer, and the light-emitting layer may emit white light or other monochromatic light. The color film layer is provided with a plurality of light-filtering parts in one-to-one correspondence with the light-emitting units, one light-filtering part and a corresponding light-emitting unit may constitute a sub-pixel, and a plurality of sub-pixels constitute a pixel. The colors of the light transmittable by different light-filtering parts may be different, thereby enabling that luminous colors of different sub-pixels may be different. The same pixel includes a plurality of sub-pixels with different colors, for example, one pixel may include three sub-pixels with luminous colors of red, green and blue respectively. As a result, color display can be achieved through a plurality of pixels.

In addition, in order to improve the brightness of the display panel, a plurality of lenses may be provided at a side of the color film layer away from the driving backplane, and one lens may be overlapped with one light-emitting unit, enabling that the relatively dispersed light emitted from the light-emitting unit is converged through the lenses, i.e., converging of light is achieved, thereby improving the brightness. However, the converging of light may narrow the light output range of the display panel, resulting in reduction of the view angle. Whereas the surface of the lens is usually an arc-shaped surface, and the light is converged towards the optical axis (perpendicular to the driving backplane), resulting in a narrow range of high brightness, which greatly limits the user's viewing range.

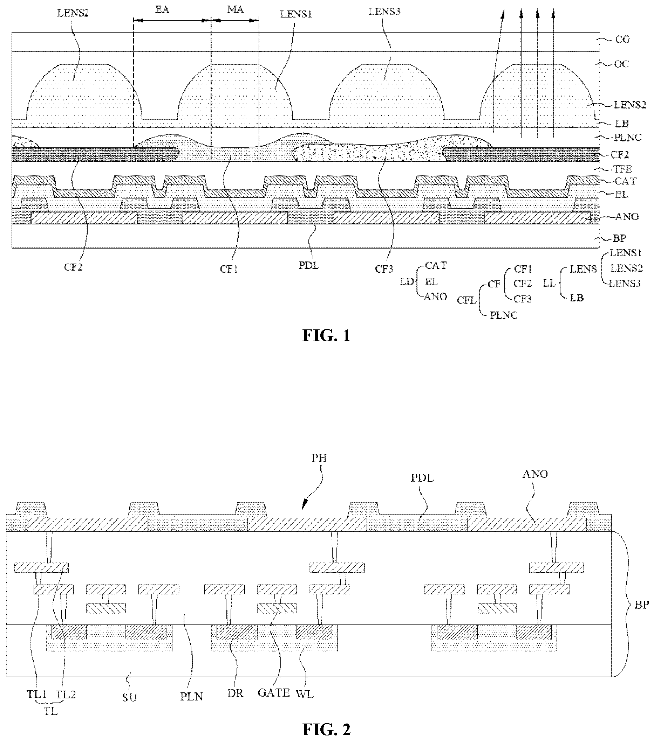

An embodiment of the present disclosure provides a display panel, as shown in FIGS. 1 and 4-9, the display panel may include a driving backplane BP, a light-emitting unit LD, a color film layer CFL, and a lens layer LL.

The number of the light-emitting units LD is multiple, and the light-emitting units LD are arranged in an array at a side of the driving backplane BP.

The color film layer CFL is located at a side of the light-emitting unit LD away from the driving backplane BP, and includes a plurality of light-filtering parts CF, where one of the light-filtering parts CF is overlapped with one of the light-emitting units LD; the light-filtering parts CF include a first light-filtering part CF 1, and the light-filtering part CF is away from and includes a middle region MA and an edge region EA surrounding the middle region MA.

The lens layer LL is located on a surface of the color film layer CFL away from the driving backplane BP, and includes a plurality of lenses LENS arranged in an array, where one of the lenses LENS is overlapped with one of the light-filtering parts CF; the lens LENS includes a top surface TS and a side surface SS surrounding an edge of the top surface TS; the side surface SS is a curved surface contracted towards the top surface TS; the lenses LENS include a first lens LENS1 overlapped with the first light-filtering part CF1; in one of first lenses LENS1 and the first light-filtering part CF1 overlapped with the one of the first lenses LENS1, the middle region MA is overlapped with the top surface TS, and the side surface SS is overlapped with the edge region EA.

In a cross section of one of the lenses LENS and the light-filtering part CF overlapped with the one of the lenses LENS, where the cross section is perpendicular to the driving backplane BP: a curvature of any point of a contour of the top surface TS is smaller than a curvature of any point of a contour of the side surface SS; a curvature difference between two points opposite to each other, in a direction perpendicular to the driving backplane BP, of a contour of the middle region MA and the contour of the top surface TS is a center curvature difference between the lens LENS and the light-filtering part CF overlapped with the lens LENS; a curvature difference between two points opposite to each other, in the direction perpendicular to the driving backplane BP, of the contour of the side surface SS and a contour of the edge region EA is an edge curvature difference between the lens LENS and the light-filtering part CF overlapped with the lens LENS; and the center curvature difference is smaller than the edge curvature difference.

In the display panel of the embodiment of the present disclosure, the surface of the lens LENS is at least divided into the side surface SS and the top surface TS, and the curvature of the side surface SS and the curvature of the top surface TS are limited, i.e., in the cross section of one of the lenses LENS and the light-filtering part CF overlapped with the one of the lenses LENS, where the cross section is perpendicular to the driving backplane BP: the curvature of any point of the contour of the top surface TS is smaller than the curvature of any point of the contour of the side surface SS. This makes the top surface TS more gentle compared to the side surface SS, and the top surface TS has a weaker converging effect on the light than the side surface SS, so that the light emerged at a large angle can be converged through the side surface SS, thereby increasing the frontal brightness, and the top surface TS can prevent excessive concentration of light, thereby preventing the high brightness area from being too narrow, which is beneficial for increasing the view angle. Thus, the view angle can be maximized under the premise of increasing the brightness, achieving a consideration for both the brightness and the view angle.

The structure of the display panel of the present disclosure that implements display functions is described in detail below:

The display panel may include a display area and a peripheral area, the peripheral area is located outside the display area and may surround the display area. The driving backplane BP is configured to form a driving circuit for driving the light-emitting unit LD to emit light, and the driving circuit may include a pixel circuit and a peripheral circuit.

The number of the pixel circuits and the number of the light-emitting units LD may both be multiple, and at least a portion of the pixel circuits is located in the display area. The pixel circuits may be pixel circuits such as 2T1C, 4T1C, and so on, as long as they are capable of driving the light-emitting units LD to emit light, and the structures of the pixel circuits are not specifically limited herein. The number of the pixel circuits is the same as the number of the light-emitting units LD. The pixel circuits are connected in one-to-one correspondence to the light-emitting units LD, thereby facilitating control of each of the light-emitting units LD for emitting light respectively. In this embodiment, nTmC indicates that one pixel circuit includes n transistors (indicated by the letter "T") and m capacitors (indicated by the letter "C"). Of course, a same pixel circuit may also drive multiple light-emitting units LD.

The peripheral circuit is located in the peripheral area and is connected to the pixel circuit. The peripheral circuit may include a light-emitting control circuit, a gate driving circuit, a source driving circuit, and the like. In addition, the peripheral circuit may further include a power supply circuit connected to the light-emitting unit LD, where the power supply circuit is configured to input a power supply signal to the light-emitting unit LD. As a result, the peripheral circuit may cause the light-emitting unit LD to emit light through the pixel circuit and by directly inputting a signal to the light-emitting unit LD.

In some embodiments of the present disclosure, as shown in FIGS. 1-3, the driving backplane BP may include a substrate SU, the substrate SU may be a silicon substrate, and the above-described driving circuit may be formed on the silicon substrate through a semiconductor process, e.g., the pixel circuit and the peripheral circuit may each include a plurality of transistors, a well region WL may be formed in the silicon substrate through a doping process, and the well region WL is provided with two doped zones DR arranged at intervals. Taking one well region WL as an example, a gate GATE is provided at a side of the driving backplane BP, an orthographic projection of the gate GATE on the driving backplane BP is located between two doped zones DR, the well region WL and the gate GATE may form a transistor, the doped zones DR of the well region WL are the first electrode and the second electrode of the transistor respectively, and the well region WL between the two doped zones DR is the channel region of the transistor.

The driving backplane BP may also include at least one wiring layer TL and a planarization layer PLN. The wiring layer TL is located at a side of the substrate SU, and the planarization layer PLN covers the wiring layer TL. At least one wiring layer TL is connected to the doped zones DR.

For example, as shown in FIG. 2, the number of the wiring layers TL is two, and the wiring layers TL are located in the planarization layer PLN. For example, the wiring layers TL include a first wiring layer TL1 and a second wiring layer TL2. The first wiring layer TL1 is located at a side of the substrate SU, and a portion of the planarization layer PLN is provided between the first wiring layer TL1 and the substrate SU. The second wiring layer TL2 is located at a side of the first wiring layer TL1 away from the substrate SU, and is separated from the first wiring layer TL1 by a portion of the planarization layer PLN. At least a partial region of the second wiring layer TL2 is connected to the first wiring layer TL1.

The wiring layers TL may be formed through a sputtering process. The material of the planarization layer PLN may be silicon oxide, silicon nitride oxide, or silicon nitride, and the planarization layer PLN may be formed layer by layer through multiple depositions and a polishing process. That is to say, the planarization layer PLN may be formed by a plurality of insulating film layers through stacking, and the plurality of film layers are not distinguished in the accompanying drawings.

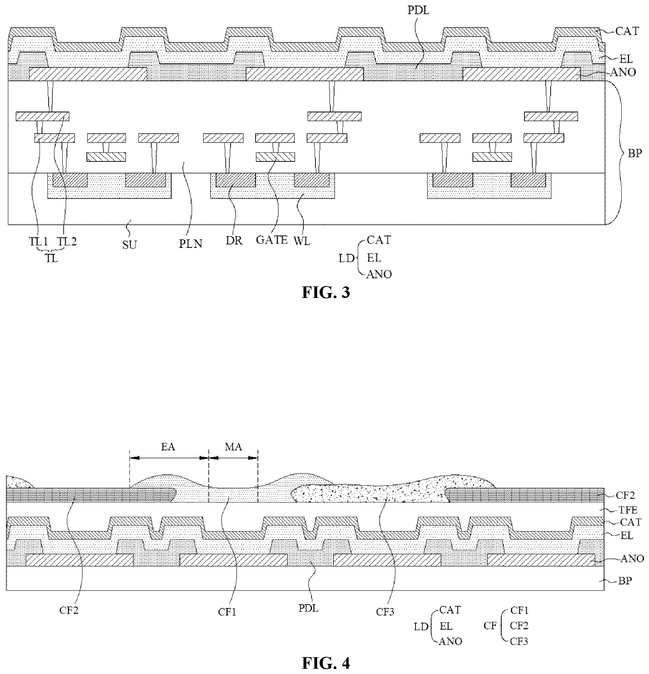

As shown in FIGS. 2 and 3, the light-emitting units LD are arranged in an array at a side of the driving backplane BP. For example, the light-emitting units LD are located on a surface of the planarization layer PLN away from the substrate SU. Each light-emitting unit LD may include a first electrode ANO, a second electrode CAT and a light-emitting layer EL located between the first electrode ANO and the second electrode CAT. Both the first electrode ANO and the second electrode CAT may be connected to the wiring layer TL. Through the driving backplane BP, a driving signal is applied to the first electrode ANO, and a power supply signal is applied to the second electrode CAT, thereby driving the light-emitting layer EL to emit light.

In order to prevent crosstalk between adjacent ones of the light-emitting units LD, a pixel definition layer PDL may be used to separate the light-emitting units LD and limit the range of the light-emitting unit LD.

In some embodiments of the present disclosure, as shown in FIGS. 1-3, the first electrode ANO is located at a side of the driving backplane BP, for example, the first electrode ANO is located on the surface of the planarization layer PLN away from the substrate SU. Each of the first electrodes ANO is located in the display area and connected to the pixel circuit, with one first electrode ANO connected to one pixel circuit.

The first electrode ANO may be a single-layer or multi-layer structure, and its material is not specifically limited herein. For example, the first electrode ANO may include a first conductive layer, a second conductive layer and a third conductive layer that are sequentially stacked along the direction away from the driving backplane BP, where the anti-corrosion degree of the first conductive layer and the anti-corrosion degree of the third conductive layer are higher than the anti-corrosion degree of the second conductive layer. For example, the material of the second conductive layer is aluminum, and the material of the first conductive layer and the material of the third conductive layer are titanium. In addition, a fourth conductive layer made of indium tin oxide or other materials may be used to cover the stacked first conductive layer, second conductive layer and third conductive layer.

As shown in FIGS. 1-3, the pixel definition layer PDL and the first electrode ANO are located on the same surface of the driving backplane BP. For example, the pixel definition layer PDL is located on the surface of the planarization layer PLN away from the substrate SU, and exposes each of the first electrodes ANO. Specifically, the pixel definition layer PDL may be provided with a plurality of pixel openings that expose the first electrodes ANO.

An orthographic projection of any pixel opening on the driving backplane BP may be located within the first electrode ANO exposed by the pixel opening, that is, the pixel opening is not larger than the first electrode ANO exposed by the pixel opening. For example, a boundary of the pixel opening is located inside a boundary of the first electrode ANO exposed by the pixel opening, that is, an area of the pixel opening is smaller than an area of the first electrode ANO exposed by the pixel opening, thereby enabling that the pixel definition layer PDL covers the edge of the first electrode ANO.

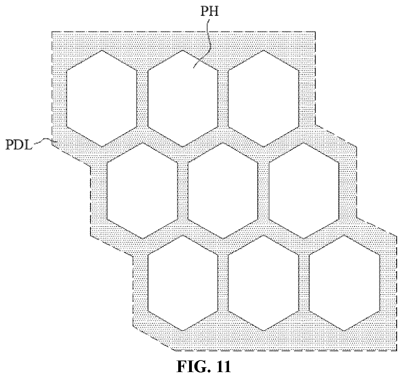

As shown in FIG. 11, the shape of the pixel opening may be a polygon such as a rectangle, a pentagon, or a hexagon, etc., but not necessarily a regular polygon. The shape of the pixel opening may also be an ellipse or other shape, and is not specifically limited here.

As shown in FIGS. 1-3, the light-emitting layer EL covers the pixel definition layer PDL and the first electrode ANO. The region where the light-emitting layer EL is stacked with the first electrode ANO is used to form the light-emitting unit LD. That is to say, the light-emitting units LD may share the same light-emitting layer EL, and the portions of the light-emitting layer EL stacked on different first electrodes ANO belong to different light-emitting units LD. In addition, because the light-emitting units LD share the same light-emitting layer EL, luminous colors of different light-emitting units LD are the same.

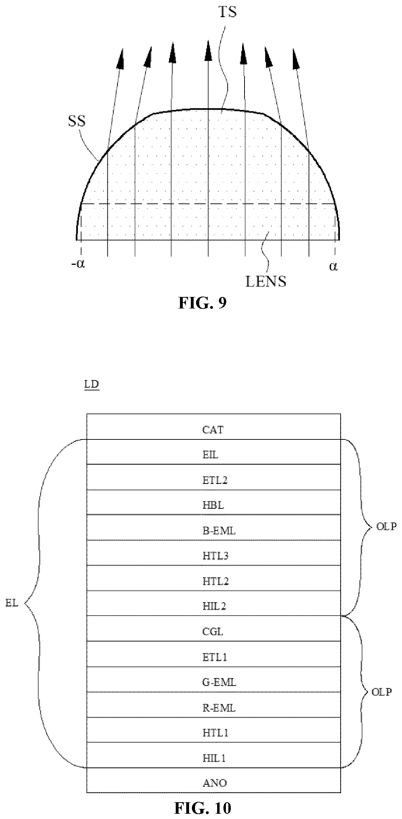

In some embodiments of the present disclosure, as shown in FIGS. 1 and 10, the light-emitting unit LD may include a plurality of light-emitting devices connected in series; each light-emitting unit includes a first electrode ANO, a second electrode CAT, and a plurality of light-emitting sub-layers OLP between the first electrode ANO and the second electrode CAT; the light-emitting devices of a same light-emitting unit LD may share a same first electrode ANO and a same second electrode CAT, that is, the same light-emitting unit LD may only have one first electrode ANO and one second electrode CAT.

For example, as shown in FIGS. 1 and 10, the light-emitting layer EL may include a hole injection layer HIL1, a plurality of light-emitting sub-layers OLP, and an electron injection layer EIL. The light-emitting sub-layers OLP are located between the hole injection layer HIL1 and the electron injection layer EIL, and are connected in series along the direction away from the driving backplane BP. In some embodiments, two adjacent ones of the light-emitting sub-layers OLP may be connected in series through a charge generation layer CGL located between the two. When an electrical signal is applied to the first electrode ANO and the second electrode CAT, each of the light-emitting sub-layers OLP can emit light, and different light-emitting sub-layers OLP may be used for emitting light of different colors.

Furthermore, as shown in FIG. 10, any light-emitting sub-layer OLP may at least include a hole transport layer HTL, a luminous material layer EML and an electron transport layer ETL that are distributed along the direction away from the driving backplane BP. The specific luminous principle will not be described in detail here.

The number of the hole injection layer HIL, the number of the hole transport layer HTL, the number of the electron transport layer ETL, and the number of the electron injection layer EIL are not specifically limited herein, and adjacent ones of the light-emitting sub-layers OLP may share one or more of the following: the hole injection layer HIL, the hole transport layer HTL, the electron transport layer ETL, and the electron injection layer EIL. Meanwhile, the charge generation layer CGL may be provided between at least two adjacent ones of the light-emitting sub-layers OLP, thereby connecting the two light-emitting sub-layers OLP in series.

In some embodiments of the present disclosure, as shown in FIG. 10, the light-emitting layer EL may include two light-emitting sub-layers OLP of different colors, namely a first light-emitting sub-layer that emits red and green light simultaneously, and a second light-emitting sub-layer that emits blue light. The first light-emitting sub-layer and the second light-emitting sub-layer may emit light simultaneously, causing the light-emitting layer EL to emit white light. In some embodiments, the first light-emitting sub-layer is provided with two luminous material layers EML, namely a luminous material layer R-EML that emits red light and a luminous material layer G-EML that emits green light. Specifically, the first light-emitting sub-layer may include a hole transport layer HTL1, a luminous material layer R-EML, a luminous material layer G-EML, and an electron transport layer ETL2 that are sequentially stacked on a hole injection layer HIL1 along the direction away from the driving backplane BP.

A surface of the first light-emitting sub-layer away from the driving backplane BP may be provided with a charge generation layer CGL. The second light-emitting sub-layer is located on a surface of the charge generation layer CGL away from the driving backplane BP, thereby enabling the first light-emitting sub-layer and the second light-emitting sub-layer to be connected in series. The second light-emitting sub-layer includes a hole injection layer HIL2, a hole transport layer HTL2, a hole transport layer HTL3, a luminous material layer B-EML that emits blue light, a hole blocking layer HBL, and an electron transport layer ETL2 that are sequentially stacked, along the direction away from the driving backplane BP, at a side of the charge generation layer CGL away from the driving backplane BP. The electron injection layer EIL is located on a surface of the electron transport layer ETL2 away from the driving backplane BP. The second electrode CAT is located on a surface of the electron injection layer EIL away from the driving backplane BP.

The above-described structure of the light-emitting layer EL is only an exemplary illustration and does not constitute a limitation on its film layer. The number of the light-emitting sub-layers OLP of the light-emitting layer EL may also be more, or the light-emitting layer EL may include only one light-emitting sub-layer OLP, as long as the light-emitting layer EL can be matched with the color film layer to achieve color display.

As shown in FIGS. 1-3, the second electrode CAT covers the light-emitting layer EL, and an orthographic projection of the second electrode CAT on the driving backplane BP may cover the display area and extend into the peripheral area. The light-emitting units LD may share a same second electrode CAT. The light-emitting layer EL may be controlled to emit light through the controlling of the power supply signal input to the second electrode CAT and the voltage of the driving signal input to the first electrode ANO.

As shown in FIGS. 1 and 4, the color film layer CFL may be located at a side of the second electrode CAT away from the driving backplane BP, and include a plurality of light-filtering parts CF. One of the light-filtering parts CF is overlapped with one of the light-emitting units LD, that is, an orthographic projection of one light-filtering part CF on the driving backplane BP is at least partially coincided with one pixel opening of one pixel definition layer PDL. For example, the light-emitting units LD are overlapped in one-to-one correspondence with the light-filtering parts CF in a direction perpendicular to the driving backplane BP. The light-filtering part CF may be divided into a plurality of portions, and at least includes a middle region MA and an edge region EA surrounding the middle region MA. The edge region EA and the middle region MA form an integrated structure.

One light-filtering part CF may absorb partial light and only transmit monochromatic light, such as red light, blue light, yellow light, etc. The light-filtering parts CF at least include a first light-filtering part CF1, a second light-filtering part CF2 and a third light-filtering part CF3 of different colors. For example, the first light-filtering part CF1 may be used for transmitting blue light, the second light-filtering part CF2 may be used for transmitting red light, and the third light-filtering part CF3 may be used for transmitting green light. The light emitted by the light-emitting units LD may be filtered by the light-filtering parts CF, thereby obtaining monochromatic light of different colors, which achieves color display.

In addition, a light-shielding structure may be provided in the color film layer CFL layer to define the light output range, and the light-shielding structure may be a separating part of a black material for separating the light-filtering parts CF; or portions of edge regions EA of adjacent ones of the light-filtering parts CF may be stacked along the direction away from the driving backplane BP, and the transparent colors of the stacked edge regions EA are different, thus achieving a shielding effect.

A width of the stacking zone is a stacking width Wp of two adjacent ones of the light-filtering parts CF. For example, the stacking width Wp may range from 0.5 µm to 0.9 µm, such as 0.5 µm, 0.6 µm, 0.7 µm, 0.8 µm, or 0.9 µm. In some embodiments, the stacking width Wp of the first light-filtering part CF1 and the second light-filtering part CF2, the stacking width Wp of the second light-filtering part CF2 and the third light-filtering part CF3, and the stacking width Wp of the first light-filtering part CF1 and the third light-filtering part CF3 may be the same or different.

As shown in FIGS. 1 and 4, and FIGS. 7 and 8, in some embodiments of the present disclosure, one first light-filtering part CF1 is adjacent to one second light-filtering part CF2 and one third light-filtering part CF3 simultaneously, and is located between the second light-filtering part CF2 and the third light-filtering part CF3. Meanwhile, a side of the second light-filtering part CF2 away from the first light-filtering part CF1 is adjacent to another third light-filtering part CF3. There is no other light-filtering part CF between adjacent ones of the light-filtering parts CF.

In the first light-filtering part CF1 and the second light-filtering part CF2 adjacent to each other, the edge region EA of the second light-filtering part CF2 is partially stacked at a side of the edge region EA of the first light-filtering part CF1 away from the driving backplane BP. In the third light-filtering part CF3 and the second light-filtering part CF2 adjacent to each other, a portion of a surface of the edge region EA of the third light-filtering part CF3 away from the driving backplane BP is curved along the direction away from the driving backplane BP, and is stacked on a side of the edge region EA of the second light-filtering part CF2 away from the driving backplane BP. Meanwhile, in the third light-filtering part CF3 and the first light-filtering part CF1 adjacent to each other, the edge region EA of the third light-filtering part CF3 is stacked at a side of the edge region EA of the first light-filtering part CF1 close to the driving backplane BP.

As shown in FIG. 4, when the light-filtering part CF of this embodiment is formed, the second light-filtering part CF2 may be first formed through a mask process, enabling that the second light-filtering part CF2 does not cover other light-filtering parts CF; then, the third light-filtering part CF3 is formed, enabling that the third light-filtering part CF3 can cover a partial area of the second light-filtering part CF2; finally, the first light-filtering part CF1 is formed, which can simultaneously cover a partial area of the second light-filtering part CF2 and a partial area of the third light-filtering part CF3, thereby achieving the above-described stacking arrangement.

Based on the stacking arrangement of this embodiment, a surface of the middle region MA of the second light-filtering part CF2 away from the driving backplane BP may be parallel to the driving backplane BP, and a surface of the edge region EA of the second light-filtering part CF2 away from the driving backplane BP may be curved along a direction close to the driving backplane BP. A side wall of the second light-filtering part CF2 may expand along the direction away from the driving backplane BP. A portion of a surface of the third light-filtering part CF3 away from the driving backplane BP is curved along the direction close to the driving backplane BP, a portion of the edge region EA of the adjacent first light-filtering part CF1 is stacked on a side of the edge region EA of the adjacent third light-filtering part CF3 away from the driving backplane BP, and a portion of the edge region EA of the adjacent first light-filtering part CF1 is stacked on a side of the edge region EA of the adjacent second light-filtering part CF2 away from the driving backplane BP. A portion of a surface of the third light-filtering part CF3 away from the driving backplane BP is curved along the direction away from the driving backplane BP, and is stacked on a side, away from the driving backplane BP, of the edge region EA of the second light-filtering part CF2 adjacent to the third light-filtering part CF3.

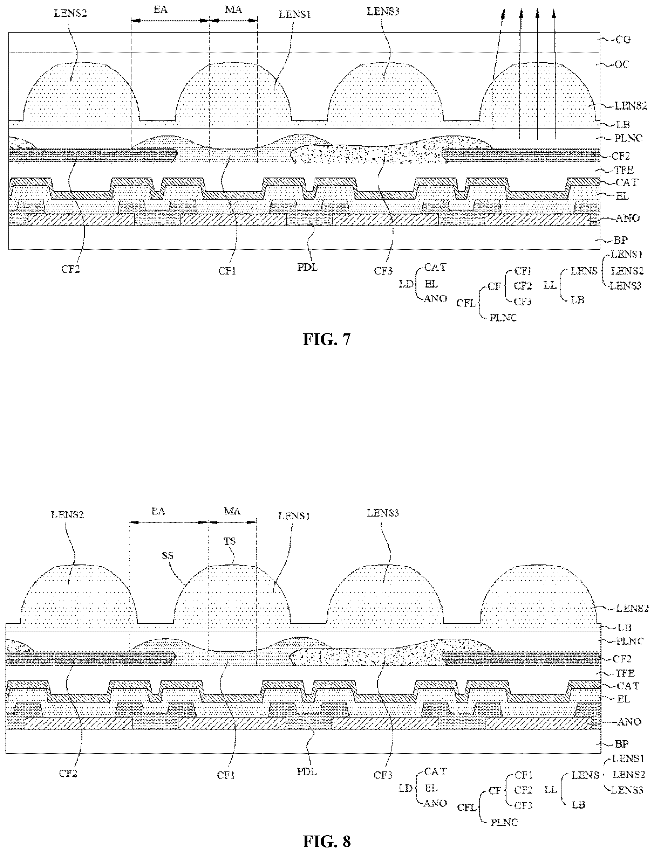

In addition, in some embodiments of the present disclosure, as shown in FIGS. 1 and 7, the color film layer CFL may further include a color film planarization layer PLNC that may cover the light-filtering parts CF, and a surface of the color film planarization layer PLNC away from the driving backplane BP may be planar, thereby achieving planarization. The color film planarization layer PLNC may be made of transparent materials such as optical adhesive, and the material of the color film planarization layer PLNC is not specifically limited herein, as long as it is transparent. The lens layer LL may be located on a surface of the color film planarization layer PLNC away from the driving backplane BP.

In some embodiments of the present disclosure, a thickness of the light-filtering part CF may range from 1.2 µm to 1.4 µm, for example, 1.2 µm, 1.3 µm, and 1.4 µm. Of course, light-filtering parts CF of different colors may have different thicknesses.

As shown in FIGS. 1, 5, 7, and 8, the lens layer LL may be located on a surface of the color film layer CFL away from the driving backplane BP, and include a plurality of lenses LENS arranged in an array. The lens LENS is a convex lens, and may include a top surface TS and a side surface SS surrounding an edge of the top surface TS. An orthographic projection of the side surface SS on the driving backplane BP is in an annular shape, and the annular shape surrounds an orthographic projection of the top surface TS on the driving backplane BP. The top surface TS may be smoothly transitioned with the side surface SS.

The side surface SS is a curved surface gradually contracted towards the top surface TS, and the curved surface may be a spherical surface, an ellipsoidal surface or a parabolic surface. One of the lenses LENS may be overlapped with one of the light-filtering parts CF, thereby being overlapped with one of the light-emitting units LD. The number of the lenses LENS is multiple, and the lenses are overlapped in one-to-one correspondence with the light-filtering parts CF. Furthermore, the top surface TS of one lens LENS may be overlapped with the middle region MA of the light-filtering part CF overlapped with the lens LENS, while the side surface of the lens LENS may be overlapped with the edge region EA of the light-filtering part CF overlapped with the lens LENS. At least a portion of the light emitted by one light-emitting unit LD, after passing through the light-filtering part CF overlapped with the light-emitting unit LD, may pass through the lens LENS overlapped with the light-filtering part CF, and the lens LENS may converge the light, thereby increasing the brightness.

The lenses LENS are arranged at intervals, and a distance between adjacent ones of the lenses LENS may be defined as a lens spacing Wl. The lens spacing Wl between any two adjacent ones of the lenses LENS may be equal. For example, the lens spacing Wl may range from 0.3 µm to 0.5 µm, such as 0.3 µm, 0.4 µm, and 0.5 µm.

As shown in FIGS. 1, 5, 7, and 8, in some embodiments of the present disclosure, the lens layer LL may further include a substrate LB, the substrate LB may be located at the side of the color film layer CFL away from the driving backplane BP, and the lenses LENS are located on a surface of the substrate LB away from the driving backplane BP. The substrate LB may be a transparent material, the material of the substrate LB may be the same as the material of the lens LENS, and the lens LENS and the substrate LB may form an integrated structure. Of course, the substrate LB and lens LENS may also be independent structures.

As shown in FIGS. 1, 5, 7, and 8, in some embodiments of the present disclosure, the lenses LENS may include a first lens LENS1 overlapped with the first light-filtering part CF1, a second lens LENS2 overlapped with the second light-filtering part CF2, and a third lens LENS3 overlapped with the third light-filtering part CF3.

As shown in FIGS. 1 and 7, in some embodiments of the present disclosure, the display panel of the present disclosure may further include an encapsulation layer TFE, which may be located at a side of the second electrode CAT away from the driving backplane BP, and located between the color film layer CFL and the second electrode CAT, and is used for blocking the erosion of external water and oxygen. The encapsulation layer TFE may be a single-layer or multi-layer structure. For example, the encapsulation layer TFE may include a first encapsulation sub-layer, a second encapsulation sub-layer and a third encapsulation sub-layer that are sequentially stacked along the direction away from the driving backplane BP. In some embodiments, the material of the first encapsulation sub-layer and the material of the second encapsulation sub-layer may be inorganic insulating materials such as silicon nitride and silicon oxide, and the second encapsulation sub-layer may be formed by using an atomic layer deposition (ALD) process; the material of the third encapsulation sub-layer may be organic materials, and the third encapsulation sub-layer may be formed by using a molecular layer deposition (MLD) process. Of course, the encapsulation layer TFE may also be other structures, and there is no special limitation on the structure of the encapsulation layer TFE herein.

As shown in FIGS. 1 and 7, in some embodiments of the present disclosure, the display panel may further include an adhesive layer OC and a transparent cover plate CG, and the transparent cover plate CG may be adhered to a side of the lens layer LL away from the driving backplane BP through the adhesive layer OC. For example, the adhesive layer OC may cover the lenses LENS, and a surface of the adhesive layer OC away from the driving backplane BP may be planar, thereby achieving planarization. Meanwhile, the adhesive layer OC has a smaller refractive index than the lens LENS, ensuring that the refractive angle is greater than the incident angle of the light propagating from the lens LENS to the adhesive layer OC, thereby facilitating the converging of the light.

The transparent cover plate CG may be attached to the surface of the adhesive layer OC away from the driving backplane BP. The transparent cover plate CG may be a single-layer or multi-layer structure, and its material is not specifically limited herein.

Based on the display panel described in the foregoing embodiment, in order to improve the brightness while avoiding excessive narrowing of the view angle, the shapes and sizes of the lens LENS and the light-filtering part CF may be defined. The specific scheme will be explained below.

Firstly, as shown in FIGS. 1, 5, 7, and 8, the top surface TS of the lens LENS may be made more gentle than the side surface SS of the lens LENS, that is, a curving degree of the top surface TS is smaller than a curving degree of the side surface SS, thereby weakening the converging effect of the top surface TS on the light, reducing the brightness difference of the light emerged from the top surface TS, increasing the high brightness area, and expanding the view angle. Although the effect of light converging has been weakened, the side surface SS still has a light converging effect, thus an increase in the brightness can still be ensured.

The curving degree of the top surface TS is less than the curving degree of the side surface SS, which may be defined in the following way.

In a cross section of one of the lenses LENS and the light-filtering part CF overlapped with the one of the lenses LENS, where the cross section is perpendicular to the driving backplane BP: a curvature of any point of a contour of the top surface TS is smaller than a curvature of any point of a contour of the side surface SS. This cross section may be a cross section passing through the optical axis of the lens LENS and perpendicular to the driving backplane BP. Examples are as follows.

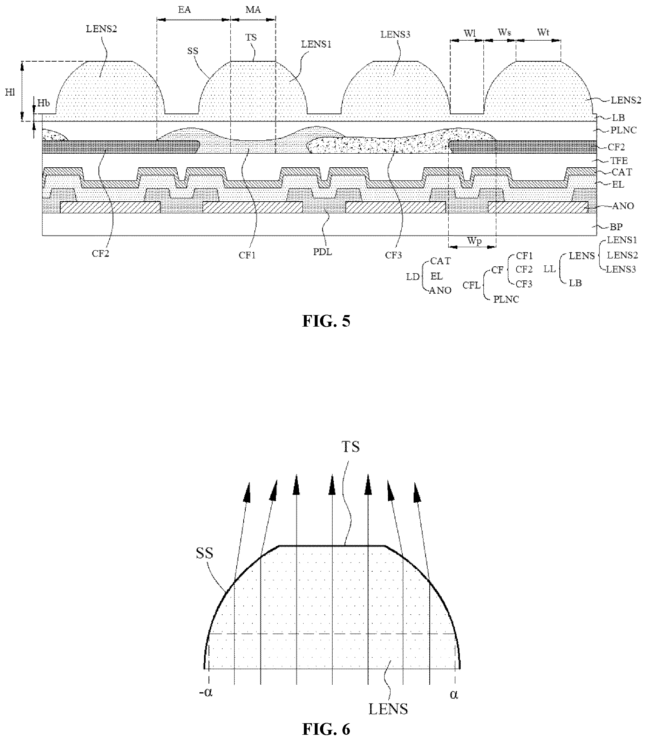

As shown in FIGS. 1 and 5, in some embodiments of the present disclosure, the top surface TS may be planar and may be parallel to the driving backplane BP, while the side surface SS is spherical. At this point, the curvature of any point on the top surface TS is zero, and the curvature of any point on the side surface SS is greater than the curvature of the top surface TS.

As shown in FIGS. 7 and 8, in other embodiments of the present disclosure, both the top surface TS and the side surface SS are spherical, but a radius of the top surface TS is smaller than a radius of the side surface.

In other embodiments of the present disclosure, the top surface TS and the side surface SS of the lens LENS may also be other shapes, as long as the curving degree of the top surface TS is smaller than the curving degree of the side surface SS, enabling that the light converging effect of the top surface TS is weaker than the light converging effect of the side surface SS.

Secondly, as shown in FIGS. 1, 5, 7, and 8, a surface of at least a portion of the light-filtering parts CF away from the driving backplane BP is recessed towards the driving backplane BP, and a curving degree of the middle region MA is less than a curving degree of the edge region EA. For example, the surface of the first light-filtering part CF1 away from the driving backplane BP is recessed towards the driving backplane BP, and the curving degree of the middle region MA is less than the curving degree of the edge region EA, which may generate a converging effect on the transmitted light, thereby enabling the light to be converged before passing through the first lens LENS, which is beneficial for improving the brightness. As the curving of the surface of the light-filtering part CF away from the driving backplane BP may affect the optical path, the curvature of the top surface TS and the curvature of the side surface SS of the lens LENS are different, and the top surface TS is relatively gentle, the topography of the surface of the light-filtering part CF away from the driving backplane BP and the topography of the surface of the lens LENS may be defined specifically as follows.

In the cross section of one of the lenses LENS and the light-filtering part CF overlapped with the one of the lenses LENS, where the cross section is perpendicular to the driving backplane BP, a curvature difference between two points opposite to each other, in the direction perpendicular to the driving backplane BP, of a contour of the middle region MA and the contour of the top surface TS may be defined as a center curvature difference between the lens LENS and the light-filtering part CF overlapped with the lens LENS, and a curvature difference between two points opposite to each other, in the direction perpendicular to the driving backplane BP, of the contour of the side surface SS and a contour of the edge region EA may be defined as an edge curvature difference between the lens LENS and the light-filtering part CF overlapped with the lens LENS. This cross section may be a cross section passing through the optical axis of the lens LENS and perpendicular to the driving backplane BP.

At least the center curvature difference between the first lens LENS1 and the first light-filtering part CF1 overlapped with the first lens LENS1 may be made smaller than the edge curvature difference between the first lens LENS1 and the first light-filtering part CF1, that is, the curving degree of the middle region MA overlapped with the top surface TS of the first lens LENS1 is less than the curving degree of the edge region EA overlapped with the side surface SS. In this way, the curving degree of the first light-filtering part CF1 may be matched with the curving degree of the surface of the first lens LENS1; the small curvature difference between the top surface TS and the middle region MA is beneficial for improving the uniformity of the color gamut and brightness. Meanwhile, the curving degree of the side surface SS and the curving degree of the edge region EA are different, reducing the amount of light perpendicular to the side surface SS emerged by the edge region EA, which cannot be converged, thus ensuring the converging effect of the side surface SS.

Furthermore, in some embodiments of the present disclosure, the top surface TS of the first lens LENS1 may be planar, and the center curvature difference between the first lens LENS1 and the first light-filtering part CF1 overlapped with the first lens LENS1 is smaller than 10% of the edge curvature difference between the first lens LENS1 and the first light-filtering part CF1.

Furthermore, in some embodiments of the present disclosure, the edge region EA of the second light-filtering part CF2 does not cover the edge region EA of the first light-filtering part CF1 and the edge region EA of the third light-filtering part CF3. Therefore, a surface of the second light-filtering part CF2 away from the driving backplane BP is flatter than the first light-filtering part CF1, and the center curvature difference between the first lens LENS1 and the first light-filtering part CF1 overlapped with the first lens LENS1 is greater than the center curvature difference between the second lens LENS2 the second light-filtering part CF2 overlapped with the second lens LENS2.

In some embodiments of the present disclosure, a width Wt of an orthographic projection of the top surface TS on the driving backplane BP is greater than a width of an orthographic projection of the side surface SS on the driving backplane BP. Due to the strong converging effect of the side surface SS on the light, there will be a large gradient change in the brightness, which is not conducive to brightness uniformity. On the other hand, the top surface TS has a weak converging effect on the light (if the top surface TS is planar, there is no converging effect). Therefore, a larger top surface TS is beneficial for increasing the brightness uniformity.

In some embodiments of the present disclosure, due to the inability to converge light at the lens spacing Wl, the lens spacing Wl should not be too large, and a width of an orthographic projection, on the driving backplane BP, of the side surface SS of the lens LENS may be greater than the lens spacing Wl of adj acent ones of the lenses LENS mentioned above. Under the condition of ensuring that adjacent ones of the lenses LENS do not stick together, a small lens spacing reduces stray light transmitted between adjacent ones of the lenses LENS, which improves the converging effect, and is beneficial for increasing the brightness.

In this article, the width Ws of the orthographic projection of the side surface SS on the driving backplane BP is the distance between the inner boundary and outer boundary of the orthographic projection. The width Ws of the orthographic projection of the top surface TS on the driving backplane BP is the maximum width, in a direction parallel to the driving backplane BP, of the orthographic projection of the top surface TS on the driving backplane BP.

In some embodiments of the present disclosure, an orthographic projection of the lens LENS on the driving backplane BP may be located within an orthographic projection, on the driving backplane BP, of the light-filtering part CF overlapped with the lens LENS, thereby ensuring a sufficient lens spacing Wl while maximizing that a same lens LENS receives light emitted by a same light-filtering part CF. In addition, the lens LENS should not be too small. If the lens LENS is too small, it will be difficult for a large amount of light to pass through the lens LENS, which is not conducive to improving the brightness. The inventor, through extensive experimentation and simulation, proposed as follows.

The lens LENS may be smaller than the light-filtering part CF corresponding to the lens LENS, that is, an area of the orthographic projection of the lens LENS on the driving backplane BP is smaller than an area of the orthographic projection, on the driving backplane BP, of the light-filtering part CF overlapped with the lens LENS. For example, the area of the orthographic projection of the lens LENS on the driving backplane BP is smaller than 0.7 to 0.8 times the area of the orthographic projection, on the driving backplane BP, of the light-filtering part CF overlapped with the lens LENS.

As shown in FIG. 5, in some embodiments of the present disclosure, the lens spacing Wl between adjacent ones of the lenses LENS may be smaller than a thickness Hb of the substrate LB of the lens layer LL, which is beneficial for reducing the spacing between lenses LENS.

As shown in FIG. 5, in some embodiments of the present disclosure, the lens spacing Wl may be smaller than the stacking width Wp of adjacent ones of the light-filtering parts CF. Because the range of the stacking width Wp is opaque, it can reduce the overflow of stray light (light that does not pass through the lens LENS) and avoid color cast caused by the stray light.

As shown in FIG. 5, in some embodiments of the present disclosure, a width of an orthographic projection, on the driving backplane BP, of the side surface SS of the first lens LENS1 is greater than the stacking width Wp of the first light-filtering part CF1 and the second light-filtering part CF2 adjacent to the first light-filtering part CF1.

In order to prevent the view angle from being too small while improving the brightness, the top surface TS of the lens LENS should not be too large or too small. If the top surface TS of the lens LENS is too large, the light converging effect will be weakened too much, and the improvement in brightness will be too low. If the top surface TS of the lens LENS is too small, it will be difficult to effectively increase the view angle. In some embodiments of the present disclosure, an area of the orthographic projection of the top surface TS on the driving backplane BP may be not smaller than one-third of an area of the orthographic projection of the lens LENS on the driving backplane BP. Of course, the orthographic projection of the top surface TS on the driving backplane BP cannot completely be coincided with the orthographic projection of the lens LENS on the driving backplane BP, and must be smaller than the area of the orthographic projection of the lens LENS on the driving backplane BP.

As shown in FIG. 5, in some embodiments of the present disclosure, a thickness of the lens layer LL may be greater than a width Wt of an orthographic projection of the top surface TS on the driving backplane BP. The thickness Hl of the lens layer LL may be the sum of the thickness of the lens LENS and the thickness Hb of the substrate LB. The thickness Hl of the lens LENS may be the maximum distance, in the direction perpendicular to the driving backplane BP, between the top surface TS of the lens LENS and the color film layer CFL. Meanwhile, the thickness Hl of the lens LENS may also be greater than the width of the orthographic projection of the top surface TS on the driving backplane BP. In this way, the lens LENS can have a sufficient height, which is beneficial for increasing the curvature of the side surface SS under the condition that the coverage range is kept to be unchanged, thereby improving the light converging effect.

It should be noted that the embodiments mentioned above may be partially or completely included in a same embodiment in the absence of contradiction, and various combinations will not be illustrated herein.

As shown in FIG. 6, FIG. 6 illustrates the optical path when the top surface TS is planar. It can be seen that the top surface TS no longer converges light, while the side surface SS can converge light. At this point, the view angle at 50% of the brightness of the light emerged by the top surface TS is - α to α, where α may be 50 °. Compared to the scheme where the top surface TS and the side surface SS are located on the same sphere (experimental measurements show that the view angle at 50% of the brightness of the light emerged by the top surface TS is 30°), the view angle significantly increases when the brightness decays by half.

As shown in FIG. 9, FIG. 9 illustrates the optical path when the top surface TS is planar. It can be seen that the top surface TS no longer converges light, while the side surface SS can converge light. At this point, the view angle at 50% of the brightness of the light emerged by the top surface TS is - α to α. Compared to the scheme where the top surface TS and the side surface SS are located on the same sphere (experimental measurements show that the view angle at 50% of the brightness of the light emerged by the top surface TS is 30°), the view angle also increases significantly when the brightness decays by half.

The embodiments of the present disclosure also provide a display device, and the display device may include the display panel of any of the above embodiments. The specific structure and beneficial effects of the display panel have been described in detail in the foregoing embodiments of the display panel, and will not be elaborated herein. The display device of the present disclosure may be used for electronic devices with image display functions such as watches, bracelets, mobile phones, tablets, etc., which will not be listed one by one herein.

After considering the specification and practicing the invention disclosed herein, those skilled in the art will easily come up with other embodiments of the present disclosure. The present application is intended to cover any variations, uses or adaptive changes of the present disclosure, and the variations, uses or adaptive changes follow the general principles of the present disclosure and include common knowledge or customary technical means in the art not disclosed in the present disclosure. The specification and embodiments are only considered exemplary, and the true scope and spirit of the present disclosure are indicated by the appended claims.

## Claims

1. A display panel, comprising:
a driving backplane;
a plurality of light-emitting units, arranged in an array at a side of the driving backplane;
a color film layer, located at a side of the light-emitting unit away from the driving backplane, and comprising a plurality of light-filtering parts, wherein one of the light-filtering parts is overlapped with one of the light-emitting units; the light-filtering parts comprise a first light-filtering part; the light-filtering part is away from and comprises a middle region and an edge region surrounding the middle region; and a surface of the first light-filtering part away from the driving backplane is recessed towards the driving backplane; and
a lens layer, located on a surface of the color film layer away from the driving backplane, and comprising a plurality of lenses arranged in an array, wherein one of the lenses is overlapped with one of the light-filtering parts; the lens comprises a top surface and a side surface surrounding an edge of the top surface; the side surface is a curved surface contracted towards the top surface; the lenses comprise a first lens overlapped with the first light-filtering part; and in one of first lenses and the first light-filtering part overlapped with the one of the first lenses, the middle region is overlapped with the top surface, and the side surface is overlapped with the edge region; wherein
in a cross section of one of the lenses and the light-filtering part overlapped with the one of the lenses, wherein the cross section is perpendicular to the driving backplane:
a curvature of any point of a contour of the top surface is smaller than a curvature of any point of a contour of the side surface;
a curvature difference between two points opposite to each other, in a direction perpendicular to the driving backplane, of a contour of the middle region and the contour of the top surface is a center curvature difference between the lens and the light-filtering part overlapped with the lens;
a curvature difference between two points opposite to each other, in the direction perpendicular to the driving backplane, of the contour of the side surface and a contour of the edge region is an edge curvature difference between the lens and the light-filtering part overlapped with the lens; and
the center curvature difference is smaller than the edge curvature difference.

2. The display panel according to claim 1, wherein an orthographic projection of the side surface on the driving backplane is in an annular shape; and an orthographic projection of the top surface on the driving backplane has a greater width than the orthographic projection of the side surface on the driving backplane.

3. The display panel according to claim 1, wherein the center curvature difference between the first lens and the first light-filtering part overlapped with the first lens is smaller than 10% of the edge curvature difference between the first lens and the first light-filtering part.

4. The display panel according to claim 1, wherein the lenses further comprise a second lens; the light-filtering parts further comprise a second light-filtering part provided with a color different from a color of the first light-filtering part; and the second light-filtering part is overlapped with the second lens; and
the center curvature difference between the first lens and the first light-filtering part overlapped with the first lens is greater than the center curvature difference between the second lens and the second light-filtering part overlapped with the second lens.

5. The display panel according to claim 4, wherein portions of edge regions of two adjacent ones of the light-filtering parts are stacked along a direction away from the driving backplane, and a width of a stacking zone is a stacking width of the two adjacent ones of the light-filtering parts.

6. The display panel according to claim 5, wherein a surface of the middle region of the second light-filtering part away from the driving backplane is parallel to the driving backplane, and a surface of the edge region of the second light-filtering part away from the driving backplane is curved along a direction close to the driving backplane; and
one first light-filtering part is adjacent to at least one second light-filtering part; and in the first light-filtering part and the second light-filtering part adjacent to each other, the edge region of the first light-filtering part is partially stacked on a side of the edge region of the second light-filtering part away from the driving backplane.

7. The display panel according to claim 6, wherein a width of an orthographic projection, on the driving backplane, of the side surface of the first lens is greater than the stacking width of the first light-filtering part and the second light-filtering part adjacent to the first light-filtering part.

8. The display panel according to claim 6, wherein the lenses further comprise a third lens; the light-filtering parts further comprise a third light-filtering part provided with a color different from the color of the first light-filtering part and the color of the second light-filtering part; and the third light-filtering part is overlapped with the third lens; and
one third light-filtering part is adjacent to at least one first light-filtering part and at least one second light-filtering part simultaneously; in the third light-filtering part and the first light-filtering part adjacent to each other, a portion of a surface of the edge region of the third light-filtering part away from the driving backplane is curved along the direction away from the driving backplane, and is stacked at a side of the edge region of the first light-filtering part away from the driving backplane; and in the third light-filtering part and the second light-filtering part adjacent to each other, a portion of a surface of the edge region of the third light-filtering part away from the driving backplane is curved along the direction close to the driving backplane, and is stacked on a side of the edge region of the second light-filtering part close to the driving backplane.

9. The display panel according to any one of claims 1-8, wherein the lenses are arranged at intervals, a spacing between two adjacent ones of the lenses is a lens spacing, and a width of an orthographic projection of the side surface on the driving backplane is greater than the lens spacing.

10. The display panel according to claim 5, wherein the lenses are arranged at intervals, a spacing between two adjacent ones of the lenses is a lens spacing, and the lens spacing is smaller than the stacking width.

11. The display panel according to any one of claims 1-10, wherein an area of an orthographic projection of the top surface on the driving backplane is not smaller than one-third of an area of an orthographic projection of the lens on the driving backplane.

12. The display panel according to any one of claims 1-11, wherein an orthographic projection of the lens on the driving backplane is located within an orthographic projection, on the driving backplane, of the light-filtering part overlapped with the lens; and an area of the orthographic projection of the lens on the driving backplane is 0.7 to 0.8 times an area of the orthographic projection, on the driving backplane, of the light-filtering part overlapped with the lens.

13. The display panel according to any one of claims 1-12, wherein a thickness of the lens layer is greater than a width of an orthographic projection of the top surface on the driving backplane.

14. The display panel according to claim 1, wherein the lens layer further comprises a substrate, and the lenses are located on a surface of the substrate away from the driving backplane.

15. The display panel according to claim 14, wherein the lenses are arranged at intervals, a spacing between two adjacent ones of the lenses is a lens spacing, and the lens spacing is smaller than a thickness of the substrate.

16. The display panel according to claim 10, wherein the lens spacing ranges from 0.3 µm to 0.5 µm; a thickness of the light-filtering part ranges from 1.2 µm to 1.4 µm; and the stacking width ranges from 0.5 µm - 0.9 µm.

17. The display panel according to any one of claims 1-16, wherein the top surface is planar, and is smoothly transitioned with the side surface.

18. The display panel according to claim 1, further comprising:
a color film planarization layer, covering the light-filtering parts; wherein
the lens layer is located on a surface of the color film planarization layer away from the driving backplane.

19. The display panel according to claim 1, further comprising:
an adhesive layer, covering the lens layer, wherein the adhesive layer has a smaller refractive index than the lens; and
a transparent cover plate, located on a surface of the adhesive layer away from the driving backplane.

20. A display device, comprising the display panel according to any one of claims 1-19.
